# EUROPÄISCHE PATENTSCHRIFT

(11) **EP 2 721 735 B1**
(45) Veröffentlichungstag und Bekanntmachung des Hinweises auf die Patenterteilung: **20.05.2015**
(21) Anmeldenummer: 12738085.5
(22) Anmeldetag: 13.07.2012
(51) Int. Cl.: H03K 17/082, H03K 17/10

(54) **SCHALTUNGSANORDNUNG MIT EINEM HALBLEITERSCHALTER UND EINER ZUGEHÖRIGEN ANSTEUERSCHALTUNG**
CIRCUIT ARRANGEMENT HAVING A SEMICONDUCTOR SWITCH AND AN ASSOCIATED ACTUATION CIRCUIT
DISPOSITIF DE COMMUTATION COMPRENANT UN COMMUTATEUR STATIQUE ET UN CIRCUIT DE COMMANDE ASSOCIÉ

(30) Priorität: 21.07.2011 DE 102011079545
(43) Veröffentlichungstag der Anmeldung: 23.04.2014
(73) Patentinhaber: Siemens Aktiengesellschaft, 80333 München (DE)
(72) Erfinder: HANDT, Karsten, 90559 Burgthann (DE); HILLER, Marc, 91207 Laufan der Pegnitz (DE); SOMMER, Rainer, 91336 Heroldsbach (DE)
(86) Internationale Anmeldenummer: PCT/EP2012/063824
(87) Internationale Veröffentlichungsnummer: WO 2013/010949

(56) Entgegenhaltungen:
- WO-A1-2008/032113
- DE-A1- 10 245 293
- DE-A1- 10 350 361
- GRECO G ET AL: "Control of the switching transients of IGBTs series strings by high-performance drive units", INDUSTRIAL ELECTRONICS SOCIETY, 1999. IECON '99 PROCEEDINGS. THE 25TH ANNUAL CONFERENCE OF THE IEEE SAN JOSE, CA, USA 29 NOV.-3 DEC. 1999, PISCATAWAY, NJ, USA,IEEE, US, Bd. 1, 29. November 1999 (1999-11-29), Seiten 197-203, XP010366813, DOI: 10.1109/IECON.1999.822196 ISBN: 978-0-7803-5735-8
- DONGSHENG ZHOU ET AL: "A practical series connection technique for multiple IGBT devices", 32ND.ANNUAL IEEE POWER ELECTRONICS SPECIALISTS CONFERENCE. PESC 2001. CONFERENCE PROCEEDINGS. VANCOUVER, CANADA, JUNE 17 - 21, 2001; [ANNUAL POWER ELECTRONICS SPECIALISTS CONFERENCE], NEW YORK, NY : IEEE, US, Bd. 4, 17. Juni 2001 (2001-06-17), Seiten 2151-2155, XP010559255, DOI: 10.1109/PESC.2001.954438 ISBN: 978-0-7803-7067-8

## Beschreibung

Die Erfindung betrifft eine Schaltungsanordnung mit einem Halbleiterschalter, der über seinen Steuereingang mit einer Ansteuerschaltung verbunden ist, die ausgelegt ist, den Halbleiterschalter in Abhängigkeit von einem vorgebbaren Schaltsignal zu schalten. Die Schaltungsanordnung kann in einem Frequenzumrichter verwendet werden. Die Erfindung betrifft auch ein Verfahren zum Betreiben eines Halbleiterschalters mit zugehöriger Ansteuerschaltung.

Eine Schaltungsanordnung dieser Art ist aus der WO 2008/032113 A1 bekannt. Eine solche Schaltungsanordnung kann z.B. in einem Gleich- oder einem Wechselrichter eines steuerbaren Umrichters bereitgestellt sein, wie er zum Betreiben einer Drehstrommaschine verwendet werden kann.

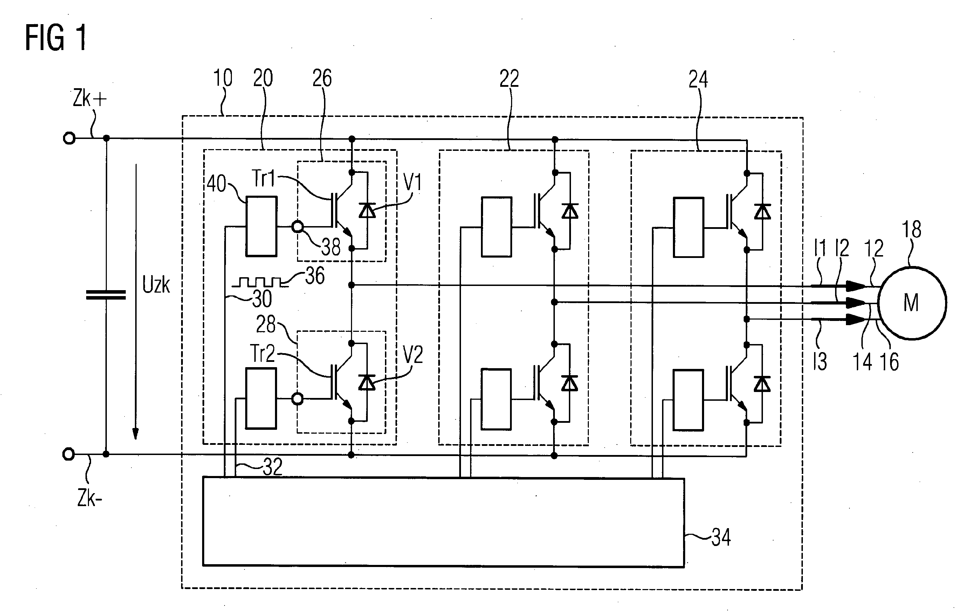

Die Funktionsweise eines steuerbaren Umrichters wird im Folgenden anhand von FIG 1 näher erläutert. Mittels eines Wechselrichters 10 können mit Hilfe einer Gleichspannung Uzk in Phasenleitern 12, 14, 16 Wechselströme 11, 12, 13 erzeugt werden, die zusammen einen Drehstrom bilden, mit dem eine elektrische Maschine 18 betrieben werden kann. Die Gleichspannung Uzk kann beispielsweise zwischen zwei Stromschienen ZK+, ZK- eines Zwischenkreises eines Frequenzumrichters bereitgestellt sein. Zum Erzeugen der Wechselströme I1, I2, I3 sind die Phasenleiter 12, 14, 16 jeweils über eine Halbbrücke 20, 22, 24 mit den Stromschienen ZK+, ZK- in der in FIG 1 gezeigten Weise verbunden. Wie die Wechselströme I1, I2, I3 erzeugt werden, ist im Folgenden im Zusammenhang mit der Halbbrücke 20 erläutert. Entsprechendes gilt auch für die Wechselströme I2 und I3 in Verbindung mit den Halbbrücken 22 und 24.

Die Halbbrücke 20 weist zwei Halbleiter-Leistungsschalter 26, 28 auf, von denen jeder einen Transistor Tr1 bzw. Tr2 und eine diesem anti-parallel geschaltete Diode V1 bzw. V2 aufweist. Über die Halbleiter-Leistungsschalter 26, 28 ist der Phasenleiter 12 einmal mit der Plus-Stromschiene ZK+ und einmal mit der Minus-Stromschiene ZK- verschaltet. Bei den Transistoren Tr1, Tr2 kann es sich z.B. um IGBT (Insulated gate bipolar transistor) oder um MOSFET (Metal oxide semiconductor field effect transistor) handeln. Die Halbleiter-Leistungsschalter 26, 28 sind jeweils über eine Steuerleitung 30, 32 mit einer Steuereinheit 34 verbunden. Die Steuereinheit 34 erzeugt ein Taktsignal 36, welches über die Steuerleitung 30 zum Halbleiter-Leistungsschalter 26 übertragen wird. Durch das Taktsignal 36 wird der Transistor Tr1 des Halbleiter-Leistungsschalters 26 abwechseln in einen leitenden und einen sperrenden Zustand geschaltet. Über die andere Steuerleitung 32 überträgt die Steuereinheit 34 ein Gegentaktsignal zum Halbleiter-Leistungsschalter 26, so dass der Transistor Tr2 des Halbleiter-Leistungsschalters 28 im Gegentakt zum Transistor Tr1 geschaltet wird. Das abwechselnde Schalten der Transistoren Tr1 und Tr2 erzeugt in dem Phasenleiter 12 eine Wechselspannung und damit den Wechselstrom I1. Zum Erzeugen des Drehstroms werden durch die Steuereinheit 34 entsprechend phasenversetzte Taktsignale über weitere Steuerleitungen an Leistungsschalter der übrigen Halbbrücken 22 und 24 übertragen. Mittels der Dioden der Halbleiter-Leistungsschalter ist es möglich, eine von der elektrischen Maschine 18 erzeugte Wechselspannung gleichzurichten.

Die von der Steuereinheit 34 erzeugten Taktsignale, wie das Taktsignal 36, sind in der Regel nicht in einer Form vorhanden, um damit einen Halbleiter-Leistungsschalter direkt ansteuern zu können. Daher ist einem Steuereingang 38 des Halbleiter-Leistungsschalters 26 eine Ansteuerschaltung 40 vorgeschaltet, welche mittels einer (nicht näher dargestellten) Verstärkerschaltung in Abhängigkeit von dem Taktsignal 36 eine Steuerspannung an dem Steuereingang 38 erzeugt. Der Steuereingang 38 ist im Falle eines Transistors dessen Gate bzw. Basis. In gleicher Weise ist dem Halbleiter-Leistungsschalter 28 eine entsprechende Ansteuerschaltung und sind auch den Leistungsschaltern der Brücken 22 und 24 entsprechende Ansteuerschaltungen vorgeschaltet.

Um Mittels des Wechselrichters 10 eine große Leistung, z.B. mehr als 50 kW, für die elektrische Maschine 18 bereitstellen zu können ohne dabei zu große Stromstärken der Wechselströme I1, I2, I3 zu erhalten, kann eine höhere Gesamtbetriebsspannung, also eine höhere Gleichspannung Uzk, verwendet werden. Diese Möglichkeit ist aber durch die maximale Sperrspannungsfähigkeit der Halbleiter-Leistungsschalter Tr1, Tr2 begrenzt. Zudem verursacht ein Betrieb eines Halbleiter-Leistungsschalters bei einer Spannung, die nahe der maximal zulässigen Sperrspannung liegt, einen größeren Verschleiß dieses Bauteils als ein Betrieb mit einer deutlich kleineren Spannung.

Im Dokument DE 103 50 361 A1 ist ein Verfahren zur Begrenzung eines Potentials am Kollektor eines abschaltbaren Leistungshalbleiterschalters während eines Abschaltvorgangs beschrieben. Das Verfahren ist insbesondere für die Begrenzung des Potentials während eines Abschaltvorgangs in einer Reihenschaltung mehrerer gleichartiger Leistungshalbleiterschalter vorgesehen. Es wird fortlaufend ein Ist-Wert des Kollektorpotentials ermittelt und durch eine zusätzliche Zeitmessung eine Ist-Spannungssteilheit bestimmt. Ist die Spannungssteilheit zu groß, das heißt steigt die Kollektorspannung mit der Zeit zu schnell an, so wird ein Ansteuersignal generiert, durch welches der Abschaltvorgang verlangsamt wird.

In dem Dokument DE 102 45 293 A1 ist ein Verfahren zum Ansteuern eines abschaltbaren Stromrichters mit einer Reihenschaltung aus mehreren Leistungshalbleiterschaltern beschrieben. Für jeden Leistungshalbleiterschalter wird die Schalterspannung über dem Leistungshalbleiterschalter erfasst und das Zeitintervall zwischen dem Eintreffen eines Ansteuerungspulses und dem Unterschreiten eines vorbestimmten Referenzwerts für die Schalterspannung bestimmt. Anschließend werden Ansteuerzeitpunkte der Leistungshalbleiterschalter auf Grundlage der bestimmten Zeitintervalle derart gegeneinander verschoben, dass die Verlustleistungen der einzelnen Leistungshalbleiterschalter beim gemeinsamen Einschalten vergleichmäßigt werden.

In einem Fachartikel von Greco G. et al. ("Control of the switching transients of IGBTs series strings by highperformance drive units", Industrial Electronics Society, 1999. IECON '99 Proceedings. The 25th Annual Conference of the IEEE San Jose, CA, USA 29 Nov. - 3 Dec. 1999, Piscataway, NJ, USA, IEEE, US, Bd. 1, 29. November 1999, Seiten 197 - 203) ist beschrieben, wie bei einer Reihenschaltung mehrerer Leistungshalbleiterschalter symmetrische Spannungsverhältnisse mittels analoger Überwachungsschaltungen erzielt werden können.

Es ist Aufgabe der vorliegenden Erfindung, eine wartungsarme Schaltvorrichtung bereitzustellen, mit der sich ein Strom auch bei verhältnismäßig großen Leistungen schalten lässt.

Die Aufgabe wird durch eine Schaltungsanordnung gemäß Patentanspruch 1 gelöst. Vorteilhafte Weiterbildungen der erfindungsgemäßen Schaltungsanordnung sind durch die Unteransprüche gegeben.

Die erfindungsgemäße Schaltungsanordnung weist eine Reihenschaltung aus zumindest zwei Halbleiterschaltern auf, d.h. eine Reihenschaltung aus den Laststrecken dieser Halbleiterschalter. In Abhängigkeit vom verwendeten Typ eines Halbleiterschalters ist dessen Laststrecke die Kollektor-Emitter-Strecke, Drain-Source-Strecke oder Anoden-Kathoden-Strecke. Durch Verwendung von zumindest zwei Halbleiterschaltern in einer Reiheschaltung ist es möglich, einen Strom auch bei einer höheren Betriebsspannung zu schalten. Zum Unterbrechen des Stromes werden dabei sämtliche Halbleiterschalter der Reihenschaltung in einen sperrenden Zustand geschaltet. Die Gesamtbetriebsspannung teilt sich dann auf die einzelnen Halbeiterschalter auf, so dass deren maximale Sperrspannungen kleiner als die Gesamtbetriebsspannung sein können. Um die einzelnen Halbleiterschalter durch Vorgabe eines Schaltsignals schalten zu können, ist der Halbleiterschalter bei der erfindungsgemäßen Schaltungsanordnung über seinen Steuereingang (Basis bzw. Gate) mit einer jeweiligen Ansteuerschaltung verbunden. Jede dieser Ansteuerschaltungen schaltet den ihr zugeordneten Halbleiterschalter in der bereits beschriebenen Weise. Dabei weist jede Ansteuerschaltung ein bestimmtes Schaltverhalten auf, also z.B. eine bestimmte Schaltverzögerung oder ein Regelverhalten, durch welches die Spannung über dem Halbleiterschalter auf einen Höchstwert begrenzt wird.

Bei der erfindungsgemäßen Schaltungsanordnung lässt sich bei zumindest einer der Ansteuerschaltungen deren Schaltverhalten durch zumindest einen digitalen Schaltparameter festlegen. Der Wert des Schaltparameters ist veränderbar, so dass das Schaltverhalten im Betrieb, also zwischen zwei Schaltvorgängen, einstellbar ist. Hierdurch ergibt sich der Vorteil, dass die Halbleiterschalter auch in einer Reihenschaltung schonend betrieben werden können. Ohne das steuerbare Schaltverhalten der Ansteuerschaltungen käme es in Folge von Parameterstreuungen bei den Halbleiterschaltern oder den Ansteuerschaltungen nämlich zu einer ungleichmäßigen Spannungsaufteilung zum einen während der Schaltvorgänge und zum anderen in der statischen Sperrphase, wenn alle Halbleiterschalter sperrend geschaltet sind. Diese Unsymmetrien können zu einer unzulässig hohen Spannungsbelastung einzelner Halbleiterschalter und zu einer unsymmetrischen Verlustaufteilung unter den Leistungsschaltern führen. Damit würden die Halbleiterschalter unterschiedlich schnell verschleißen. Durch das Einstellen des Schaltverhaltens der Ansteuerschaltungen im Betrieb kann erreicht werden, dass die über den einzelnen Halbleiterschalter abfallenden Teilspannungen besser symmetriert, Schaltverluste gleichmäßig auf die Halbleiterschalter aufgeteilt und die einzelnen Halbleiterschalter vor Überspannungen geschützt werden. Bevorzugt ist das Schaltverhalten aller Ansteuerschaltungen der erfindungsgemäßen Schaltungsanordnung im Betrieb einstellbar.

Diese Vorteile sind auch mittels eines Verfahrens erreichbar. Dieses betrifft den Betrieb einer Reihenschaltung aus zwei Halbleiterschaltern, die jeweils über eine ihnen zugeordnete Ansteuerschaltung schaltbar sind. Gemäß dem Verfahren wird zunächst ein aktueller Gesamtwert zu wenigstens einer Gesamtbetriebsgröße der Reihenschaltung ermittelt. Der Gesamtwert kann also z.B. zu wenigstens einer der im Folgenden beschriebenen Gesamtbetriebsgrößen ermittelt werden: Es kann ein Höchstwert einer während eines Schaltvorganges über der Reihenschaltung abfallenden Spannung ermittelt werden. Dieser Spannungswert kann größer als die Gesamtbetriebsspannung sein, wenn beispielsweise Induktivitäten während des Schaltvorganges eine zusätzliche Spannung induzieren. Genauso kann ein Spannungswert einer Versorgungsspannung, also der Gesamtbetriebsspannung, ermittelt werden. Die Gesamtbetriebsspannung ist diejenige elektrische Spannung, die von einer Spannungsquelle erzeugt wird, deren Ausgangsstrom mittels der Reihenschaltung geschaltet werden soll. Ein weiterer Wert, durch dessen Berücksichtigung die beschriebenen Vorteile erzielt werden können, ist ein Jitterwert, durch welchen ein Zeitversatz zwischen dem Beginn von Schaltvorgängen der Ansteuerschaltungen angegeben ist. Durch ein solches zeitlich versetztes Schalten der Halbleiterschalter, wie es durch Jitter verursacht wird, kann es vorkommen, dass die Gesamtbetriebsspannung während des versetzten Schaltens der einzelnen Halbleiterschalter vollständig über einem von diesen abfällt, wodurch dieser dann übermäßig belastet wird.

Auf Grundlage des ermittelten Gesamtwerts der wenigstens einen Gesamtbetriebsgröße werden für die einzelnen Ansteuerschaltungen jeweilige Teilgrößen ermittelt, also am Beispiel der Gesamtbetriebsspannung könnten dies etwa gleichgroße Teilspannungen sein, die jeweils über einem der Halbleiterschalter abfallen sollen. Dann wird das Schaltverhalten von zumindest einer der Ansteuerschaltungen entsprechend der für sie ermittelten Teilgröße konfiguriert. Schließlich werden die Halbleiterschalter durch Erzeugen eines Schaltsignals für jede der Ansteuerschaltungen geschaltet. Durch die Konfiguration ist zumindest eine der Ansteuerschaltungen dabei in ihrem Schaltverhalten derart festgelegt, dass sich die ermittelten Teilgrößen auch tatsächlich ergeben.

Zu dieser Form der Vorgabe von Teilgrößen ist bei der erfindungsgemäßen Schaltungsanordnung bei zumindest einer Ansteuerschaltung eine Spannungsüberwachungseinrichtung vorgesehen, die dazu ausgebildet ist, eine über dem durch die Ansteuerschaltung angesteuerten Halbleiterschalter abfallende Spannung (z.B. eine Kollektor-Emitter-Spannung) zu überwachen. Falls die Spannung größer als ein Grenzwert ist, wirkt die Spannungsüberwachungseinrichtung auf den Schaltvorgang derart ein, dass sich die Spannung auf einen Wert unterhalb des oder gleich dem Grenzwert verringert. Der Grenzwert ist dabei als ein Schaltparameter der Ansteuerschaltung in der beschriebenen Weise einstellbar. Ein möglicher Grenzwert ist die Teilspannung, die sich durch Aufteilen der während eines Schaltvorgangs durch Induktion entstehenden Höchstspannung ergibt. Durch die Spannungsüberwachungseinrichtung mit einstellbarem Grenzwert ergibt sich der Vorteil, dass die Spannung stets auf die einzelnen Halbleiterschalter aufteilbar ist.

Zusätzlich oder alternativ dazu ist bei zumindest einer der Ansteuerschaltungen als Schaltparameter ein Spannungsendwert einstellbar, welchen eine über dem durch die Ansteuerschaltung angesteuerten Halbleiterschalter abfallende Spannung am Ende eines Schaltvorgangs aufweisen soll. Die Ansteuerschaltung ist hierbei dazu ausgelegt, zum Einstellen des Spannungsendwerts zum Abschluss des Schaltvorganges zumindest einen Symmetrierimpuls am Steuereingang des Halbleiterschalters zu erzeugen. Durch den Symmetrierimpuls wird erreicht, dass der angesteuerte Halbleiterschalter kurzzeitig seinen Schaltzustand wechselt (von sperrend zu leitend oder umgekehrt) und hierdurch die über den einzelnen Halbleiterschaltern abfallenden Teilspannungen in ihren Spannungswerten angeglichen werden.

Indem der Spannungsendwert als Schaltparameter einstellbar ist, kann auch bei veränderlicher Gesamtbetriebsspannung stets erreicht werden, dass die Teilspannungen zumindest annähernd gleich groß sind, so dass die Halbleiterschalter gleichmäßig belastet werden.

Eine andere vorteilhafte Weiterbildung der erfindungsgemäßen Schaltungseinrichtung sieht vor, dass bei zumindest einer der Ansteuerschaltungen als Schaltparameter eine Schaltverzögerung einstellbar ist. Diese Ansteuerschaltung ist dabei dazu ausgelegt, nach Empfang des Schaltsignals einen Schaltvorgang um die eingestellte Schaltverzögerung verzögert zu beginnen. Hierdurch können Toleranzen der Ansteuerschaltungen und der leistungselektronischen Schalter ausgeglichen werden.

Ein weiterer Vorteil ergibt sich, wenn zumindest eine der Ansteuerschaltungen eine Spannungsmesseinrichtung zum Messen einer über zumindest einem der Halbleiterschalter abfallenden Spannung sowie einen Messausgang aufweist, an welchem ein Messwert auslesbar ist. Dann kann mittels der Schaltungsanordnung eine momentane Gesamtbetriebsspannung ermittelt werden.

Um einen Einfluss einer elektromagnetischen Störstrahlung auf das Schaltverhalten einer der Ansteuerschaltungen zu verringern, kann diese dazu ausgelegt sein, ein Signal über eine Lichtwellenleiter-Verbindung mit einem externen Gerät auszutauschen.

Eine weitere Möglichkeit, eine Ansteuerschaltung vor einer Störstrahlung zu schützen, ergibt sich, wenn diese dazu ausgelegt ist, ein Signal mittels eines fehlertoleranten Übertragungsprotokolls mit einem externen Gerät auszutauschen. Bei einer besonders bevorzugten Ausführungsform der Schaltungsanordnung wird eine der Ansteuerschaltungen als Master-Ansteuerung und die zumindest eine andere als Slave-Ansteuerung betrieben. Mit dem Begriff Slave-Ansteuerung ist gemeint, dass diese Ansteuerschaltung Daten mit einer Signalgebereinrichtung der Schaltungsanordnung, welche die Schaltsignale für die Ansteuerschaltungen erzeugt, über die Master-Ansteuerung austauscht. Indem nur die Master-Ansteuerung Daten unmittelbar mit der Signalgebereinrichtung austauscht, sind nur sehr wenige Kommunikationsleitung nötig, um Daten zwischen der Signalgebereinrichtung und den Ansteuerschaltungen auszutauschen.

Ein weiterer Vorteil ergibt sich, wenn die Ansteuerschaltungen Daten über einen Ringbus miteinander austauschen. Dann müssen nur sehr wenige Kommunikationsleitungen bereitgestellt werden, damit die Ansteuerschaltungen untereinander Daten austauschen können. Zudem können zum Bereitstellen von Daten für alle Ansteuerschaltungen Geräte vom selben Typ verwendet werden, wodurch die Herstellung der Schaltungsanordnung vereinfacht und verbilligt wird.

Die Erfindung wird im Folgenden anhand von Ausführungsbeispielen näher erläutert. Dazu zeigt:
- FIG 1: eine schematische Darstellung eines prinzipiellen Aufbaus eines Wechselrichters;
- FIG 2: eine schematische Darstellung einer Ansteuerschaltung und eines Halbleiter-Leistungsschalters, die in einer Ausführungsform der erfindungsgemäßen Schaltungsanordnung eingebaut sind;
- FIG 3: zwei Diagramme, durch die veranschaulicht ist, welchen Einfluss auf einen Abschaltvorgang Schaltparameter haben, die bei der Ansteuerschaltung von FIG 2 einstellbar sein können;
- FIG 4: einen Schaltplan zweier Reihenschaltungen von Halbleiterschaltern mit zugehörigen Ansteuerschaltungen, wobei die Reihenschaltungen jeweils eine Ausführungsform der erfindungsgemäßen Schaltungsanordnung bilden;
- FIG 5 bis FIG 7: jeweils eine schematische Darstellung einer weiteren Ausführungsform der erfindungsgemäßen Schaltungsanordnung.

Die Beispiele stellen bevorzugte Ausführungsformen der Erfindung dar.

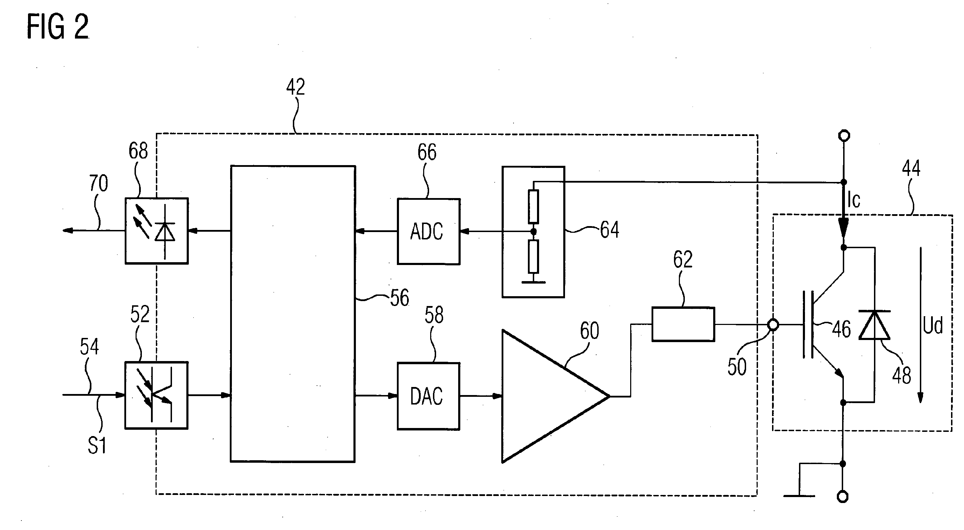

In FIG 2 ist eine Ansteuerschaltung 42 gezeigt, die in einem (in FIG 2 nicht näher dargestellten) steuerbaren Wechselrichter eines Frequenzumrichters eingebaut ist. Der Wechselrichter entspricht in seiner Funktionsweise dem in FIG 1 gezeigten Wechselrichter. Die Ansteuerschaltung 42 steuert einen Halbleiter-Leistungsschalter 44. Dieser weist einen Transistor 46 (hier einen IGBT) und eine zu diesem anti-parallel geschaltete Diode 48 auf. Anstelle des IGBT kann z.B. auch ein MOSFET vorgesehen sein. Zum Steuern des Halbleiter-Leistungsschalters 44 erzeugt die Ansteuerschaltung 42 eine Steuerspannung an einem Steuereingang 50 des Halbleiter-Leistungsschalters 44. Der Steuereingang 50 entspricht hier dem Gate des IGBT. Mittels des Halbleiter-Leistungsschalters 44 wird ein Strom Ic kontrolliert geschaltet.

Die Steuerspannung am Steuereingang 50 wird in Abhängigkeit von einem Schaltsignal S1 erzeugt, welches die Ansteuerschaltung 42 über einen Lichtempfänger oder Eingangs-Optokoppler 52 empfängt, über den die Ansteuerschaltung 42 mit einer Signalleitung 54 einer (nicht dargestellten) Wechselrichtersteuerung verbunden ist. Die Signalleitung 54 umfasst einen Lichtwellenleiter. Die Wechselrichtersteuerung umfasst eine Signalgebereinrichtung des Wechselrichters.

Das Schaltsignal S1 wird von einer programmierbaren Steuereinrichtung 56 ausgewertet. Die Steuereinrichtung 56 kann z.B. durch einen FPGA (field programmable gate array) oder einen ASIC (application-specific integrated circuit) bereitgestellt sein. Über das Schaltsignal S1 gibt die Wechselrichtersteuerung vor, ob sich der Halbleiter-Leistungsschalter 44 in einem leitenden oder einem sperrenden Zustand befinden soll. Die Steuereinrichtung 56 erzeugt ein entsprechendes digitales Signal, zu welchem von einem Digital-Analog-Wandler 58 ein analoges Signal erzeugt wird. Das analoge Signal wird von einer Verstärkerschaltung 60 verstärkt und als Steuerspannung über einen Gate-Widerstand 62 zum Steuereingang 50 übertragen. In Abhängigkeit von einem Typ der Verstärkerschaltung 60 und des Transistors 46 kann die Ansteuerschaltung 42 auch ohne einen Gate-Widerstand betrieben werden.

In der Steuereinrichtung 56 kann ein digitales Filter oder eine digitale Regelung vorgesehen sein, um aus dem Schaltsignal S1 der Wechselrichtersteuerung ein zum Ansteuern des Halbleiter-Leistungsschalters 44 geeignetes digitales Signal zu erzeugen. Zudem ist es möglich, Schutzfunktionen z.B. für den Halbleiter-Leistungsschalter 44 vorzusehen. Die Steuereinrichtung 56 bildet eine digitale Schnittstelle zwischen der Wechselrichtersteuerung und dem Halbleiter-Leistungsschalter 44.

Die Ansteuerschaltung 42 weist eine Spannungsmesseinrichtung 64 auf, mit der eine Diodenspannung Ud erfasst wird. Die Diodenspannung Ud entspricht hier zugleich der Kollektor-Emitter-Spannung Uce des Transistors 46. Über einen Analog-Digial-Wandler 66 wird der erfasste Spannungswert in einen digitalen Messwert umgewandelt, der von der Steuereinrichtung 56 ausgewertet wird. Die Diodenspannung Ud stellt eine über dem durch die Ansteuerschaltung 42 angesteuerten Halbleiter-Leistungsschalters 44 abfallende Spannung dar.

Bei der Ansteuerschaltung 42 können über einen Lichtsender oder Ausgangs-Optokoppler 68 und eine Signalleitung 70 Daten, wie z.B. digitale Messwerte oder Zustandsinformationen, zur Wechselrichtersteuerung übertragen werden. Die Signalleitung 70 umfasst einen Lichtwellenleiter.

Bei der Ansteuerschaltung 42 kann vorgesehen sein, dass zum Austauschen von Daten zwischen der Wechselrichtersteuerung und der Steuereinrichtung 56 ein fehlertolerantes Übertragungsprotokoll verwendet wird, so dass auch bei einer Verfälschung der Daten, beispielsweise durch eine elektromagnetische Störstrahlung, die ursprünglich gesendeten Informationen (bis zu einem bestimmten Grad der Verfälschung) wieder aus den verfälschten Daten rekonstruiert werden können. Beispiele für ein solches Übertragungsprotokoll sind ein Barker-Code und ein zyklischer Code.

Wenn durch das Schaltsignal S1 der Steuerleitung 54 ein Wechsel des Schaltzustands des Halbleiter-Leistungsschalters 44, also von leitend auf sperrend oder umgekehrt, durch die Wechselrichtersteuerung vorgegeben wird, so wird von der Ansteuerschaltung 42 ein entsprechender Schaltvorgang durch Verändern der Steuerspannung am Steuereingang 50 bewirkt. Das Schaltverhalten der Ansteuerschaltung 42 ist dabei durch Schaltparameter der Steuereinrichtung 56 festgelegt, deren Werte während des Betriebs der Ansteuerschaltung 42 verändert werden können. Die Werte für die Schaltparameter sind bei der Ansteuerschaltung 42 zusammen mit dem Schaltsignal S1 über die Steuerleitung 54 von der Wechselrichtersteuerung zur Steuereinrichtung 56 übertragbar.

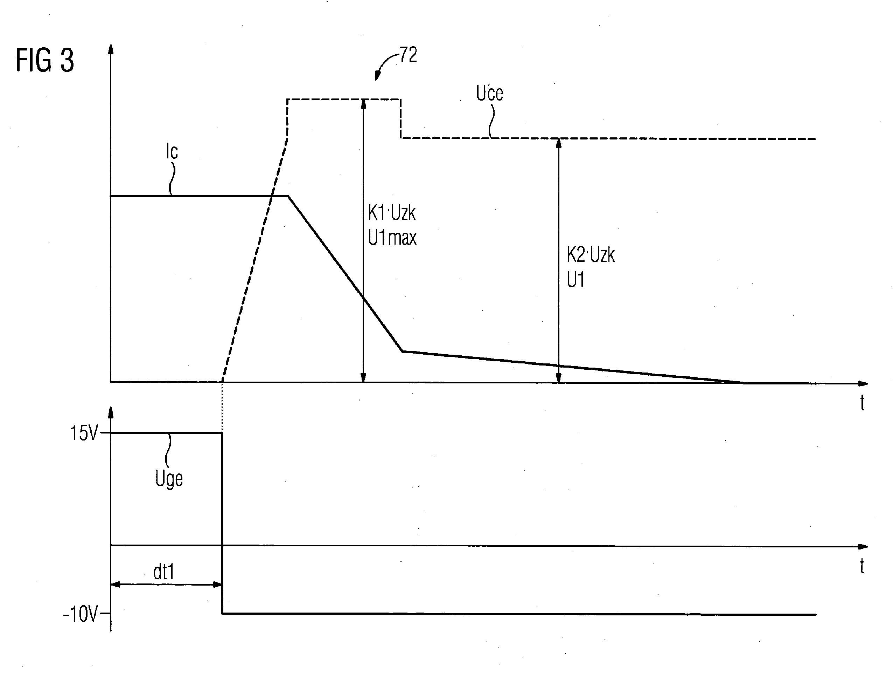

Anhand von FIG 3 ist im Folgenden erläutert, wie ein Schaltvorgang durch Einstellen von Schaltparametern auf einen bestimmten Wert beeinflussbar ist.

In FIG 3 ist ein Verlauf der Stromstärke des Stromes Ic und der Kollektor-Emitter-Spannung Uce während eines Abschaltvorganges über der Zeit t aufgetragen. Zum Unterbrechen des Stromes Ic wird seine Stromstärke graduell verringert, so dass der zeitliche Verlauf der Stromstärke während des Schaltvorganges eine endliche Steigung (Ableitung von Ic nach der Zeit während des Abschaltens) aufweist. Der Verlauf der Spannung Uce weist bei dem Abschaltvorgang eine Überhöhung 72 auf, die durch eine Spannung verursacht wird, welche durch eine (in FIG 2 nicht dargestellte) Induktivität beim Abschalten des Stromes Ic erzeugt wird.

Ein Spannungshöchstwert K1*Uzk der Kollektor-Emitter-Spannung Uce stellt einen Grenzwert dar, der nicht überschritten werden darf. Der Spannungshöchstwert K1*Uzk ist als Teilspannungswert aus einem aktuellen Wert einer Gleichspannung Uzk gebildet. Die Gleichspannung Uzk ist eine Betriebsspannung des Wechselrichters. Sie wird in einem Zwischenkreis des Frequenzumrichters bereitgestellt, an den der Wechselrichter angeschlossen ist. Die Gleichspannung Uzk wird im Folgenden auch als Zwischenkreisspannung Uzk bezeichnet. Der Spannungswert für die Zwischenkreisspannung Uzk ist von der Wechselrichtersteuerung als eine Gesamtbetriebsgröße ermittelt worden.

Der Spannungshöchstwert K1*Uzk ist als Schaltparameter bei der Steuereinrichtung 56 einstellbar. Die Spannungsmesseinrichtung 64, der Analog-Digital-Wandler 66 und die Steuereinrichtung 56 bilden in diesem Zusammenhang eine Spannungsüberwachungseinrichtung in Form eines Reglers für die Diodenspannung Ud bzw. Uce. Den gewünschten Spannungshöchstwert K1*Uzk hat die Wechselrichtersteuerung über die Steuerleitung 54 zusammen mit dem Schaltsignal S1 an die Ansteuerschaltung 42 übertragen.

Ein aktueller Spannungswert U1max während des Schaltvorgangs wird mittels der Spannungsmesseinrichtung 64 erfasst. Falls der aktuelle Spannungswert U1max größer als der Spannungshöchstwert K1*Uzk wird, wird der Schaltvorgang durch die Steuereinrichtung 56 verlangsamt, so dass sich der Betrag der Steigung des Stromstärkeverlaufs von Ic verringert.

Als ein zweiter Schaltparameter kann der Spannungsendwert K2*Uzk vorgebbar sein, welchen die Spannung Uce am Ende des Abschaltvorganges aufweisen soll. Um den Spannungsendwert K2*Uzk zu erreichen, kann vorgesehen sein, dass die Steuereinrichtung 56 den Halbleiter-Leistungsschalter 44 ein- oder mehrmals kurzzeitig durch Erzeugen eines Symmetrierimpulses wieder vom sperrenden in den leitenden Zustand schaltet, so dass kurzzeitig ein Stromfluss ermöglich ist und hierdurch eine Spannungsverlagerung im Wechselrichter möglich ist. Ein aktueller Spannungswert U1 wird über die Spannungsmesseinrichtung 64 erfasst.

Als ein dritter Parameter kann ein Schaltverzögerungswert dt1 bei der Steuereinrichtung 56 als Schaltparameter einstellbar sein. Der Schaltverzögerungswert dt1 gibt die Zeitdauer an, nach welcher die Steuereinrichtung 56 den Schaltvorgang beginnt, nachdem dieser durch das Schaltsignal S1 von der Wechselrichtersteuerung angefordert wurde. Der Schaltvorgang wird dann eingeleitet, indem am Steuereingang 50 die Gate-Emitter-Spannung Uge entsprechend dem in FIG 3 gezeigten Verlauf verändert wird.

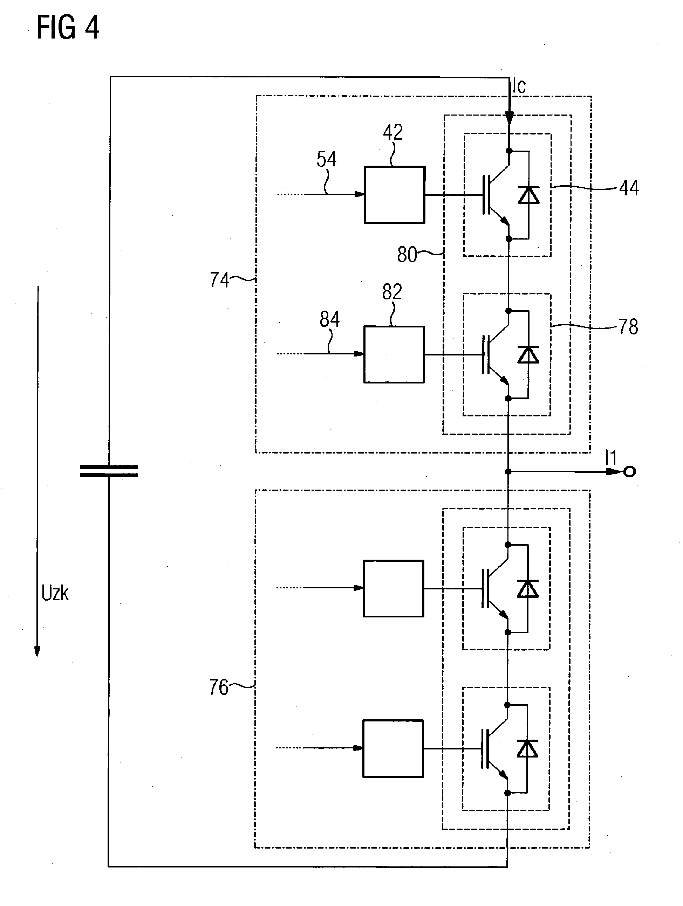

In FIG 4 ist eine Halbbrücke mit zwei Halbbrücken-Zweigen 74, 76 des Wechselrichters gezeigt, in welchen die Ansteuerschaltung 42 und der Halbleiter-Leistungsschalter 44 eingebaut sind. Die Halbbrücken-Zweige 74, 76 stellen jeweils eine Ausführungsform der erfindungsgemäßen Schaltungsanordnung dar, wobei auch die (nicht dargestellte) Wechselrichtersteuerung als Bestandteil der Schaltungsanordnung anzusehen ist. Der Halbleiter-Leistungsschalter 44 ist zusammen mit einem weiteren Halbleiter-Leistungsschalter 78 zu einer Reihenschaltung 80 verschaltet. Wie in FIG 4 durch Auslassungspunkte "..." angedeutet ist, können zusätzlich zu den beiden Halbleiter-Leistungsschaltern 44 und 78 noch weitere Halbleiter-Leistungsschalter in der Reihenschaltung 80 enthalten sein. Die Gesamtzahl der in der Reihenschaltung 80 in Reihe geschalteten Halbleiter-Leistungsschalter ist im Folgenden mit n bezeichnet.

Mittels der beiden Halbbrücken-Zweige 74, 76 wird in dem Wechselrichter ein Wechselstrom I1 erzeugt. Der Wechselstrom I1 entspricht dem Wechselstrom mit demselben Bezugszeichen in dem Wechselrichter von FIG 1. Die Reihenschaltung 80 entspricht in ihrer Funktion dem einzelnen Halbleiter-Leistungsschalter 26 des in FIG 1 gezeigten Wechselrichters. Bei dem Wechselrichter, dessen Halbbrücke in FIG 4 gezeigt ist, ist es allerdings durch die Reihenschaltung 80 möglich, dass der Wechselrichter mit einer Zwischenkreisspannung Uzk betrieben wird, die größer ist als eine maximale Sperrspannung, die höchstens über einem einzelnen der Halbleiter-Leistungsschalter 44, 78 abfallen darf. Zum Erzeugen des Wechselstroms I1 wird abwechselnd einer der Halbbrücken-Zweige 74, 76 in einen leitenden Zustand und der jeweils andere Halbbrücken-Zweig 76, 74 in einen sperrenden Zustand geschaltet. Über einem der beiden Halbleiter-Zweige 74, 76 fällt somit stets nahezu die gesamte Zwischenkreisspannung Uzk ab.

Der Halbleiter-Leistungsschalter 78 ist über einen Steuereingang mit einer eigenen Ansteuerschaltung 82 verbunden, die in ihrer Funktionsweise der Ansteuerschaltung 42 entspricht. Die Ansteuerschaltung 82 empfängt ein Schaltsignal Sn von der Wechselrichtersteuerung über ein Steuerleitung 84.

Der Halbbrücken-Zweig 76 entspricht in seiner Bauweise dem Halbbrücken-Zweig 74. Daher werden die Elemente des Halbbrücken-Zweigs 76 nicht näher erläutert.

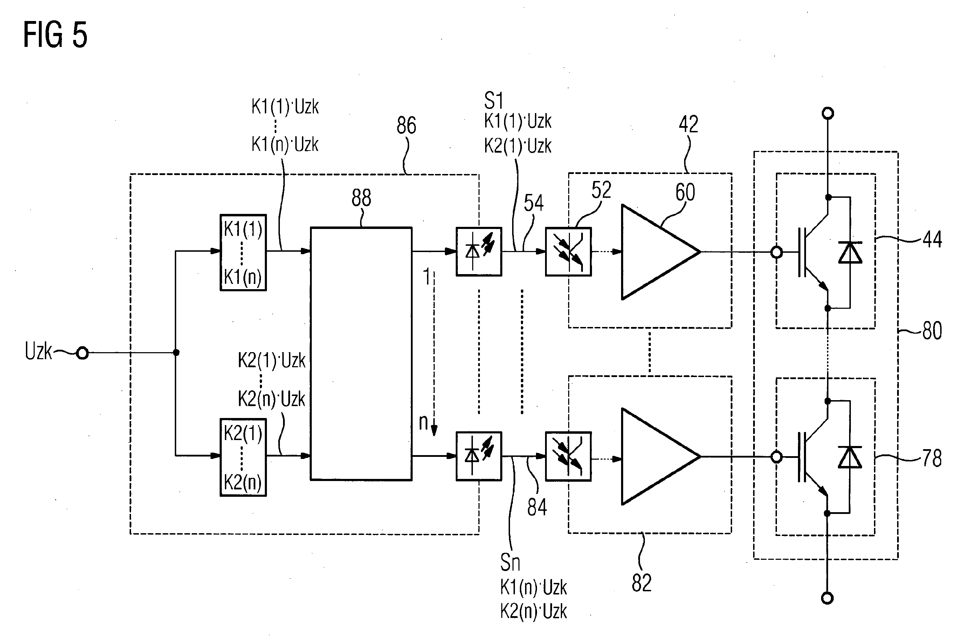

In FIG 5 bis FIG 7 ist gezeigt, wie die Ansteuerschaltungen 42 und 82 und gegebenenfalls auch weitere Ansteuerschaltungen zum einen mit der Wechselrichtersteuerung des Wechselrichters und zum anderen untereinander verschaltet sein können. Bei den gezeigten Beispielen sei angenommen, dass die Reihenschaltung 80 aus einer Gesamtanzahl n von Halbleiter-Leistungsschaltern gebildet ist, von denen in den FIG 5 bis FIG 7 der Übersichtlichkeit halber jeweils nur der erste Halbleiter-Leistungsschalter 44 mit seiner zugehörigen Ansteuerschaltung 42 sowie der letzte Halbleiter-Leistungsschalter 78 mit seiner zugehörigen Ansteuerschaltung 82 dargestellt sind.

Bei der in FIG 5 gezeigten Variante empfängt die Wechselrichtersteuerung 86 des Wechselrichters einen Messwert der Zwischenkreisspannung Uzk von einer (nicht dargestellten) Spannungsmesseinrichtung des Wechselrichters. In Abhängigkeit von der Gesamtzahl n der Halbleiter-Leistungsschalter der Reihenschaltung 80 werden Faktoren K1(1) bis K1(n) zum Berechnen von Spannungshöchstwerten K1(1)*Uzk bis K1(n)*Uzk für die Kollektor-Emitter-Spannungen der Transistoren der einzelnen Halbleiter-Leistungsschalter ermittelt. Die Werte bilden Grenzwerte, wie sie im Zusammenhang mit FIG 3 bereits erläutert wurden. Der Spannungshöchstwert K1(1)*Uzk entspricht hierbei dem im Zusammenhang mit FIG 3 erläuterten Spannungshöchstwert K1*Uzk.

Entsprechend den Faktoren K1(1) bis K1(n) werden auch Faktoren K2(1) bis K2(n) zum Berechnen von Spannungsendwerten K2(1)*Uzk bis K2(n)*Uzk berechnet, wie sie ebenfalls bereits im Zusammenhang mit FIG 3 erläutert wurden. Der Spannungsendwert K2(1)*Uzk entspricht dem im Zusammenhang mit FIG 3 beschriebenen Spannungsendwert K2*Uzk.

Die Faktoren K1(1) bis K1(n) und K2(1) bis K2(n) werden derart ermittelt, dass sich im Betrieb des Wechselrichters stets eine gleichmäßige Belastung der insgesamt n Halbleiter-Leistungsschalter der Reihenschaltung 80 ergibt.

Eine Signalgebereinrichtung 88 der Wechselrichtersteuerung 86 erzeugt für jede der Ansteuerschaltungen 1 bis n der n Halbleiter-Leistungsschalter der Reihenschaltung 80 ein Schaltsignal S1 bis Sn. Die Ansteuerschaltung 42 hat in dem gezeigten Beispiel die Ordnungsnummer 1, die Ansteuerschaltung 82 die Ordnungsnummer n. Über die Signalleitungen 54 und 84 und weitere, in FIG 5 durch Auslassungszeichen nur angedeutete Signalleitungen wird jedes der Schaltsignale S1 bis Sn zusammen mit den zugehörigen Parameterwerten für die Schaltparameter, d.h. den Spannungshöchstwerten K1(1)*Uzk bis K1(n)*Uzk und den Spannungsendwerten K2(1)*Uzk bis K2(n)*Uzk jeweils zu den Ansteuerschaltungen übertragen, für die sie bestimmt sind.

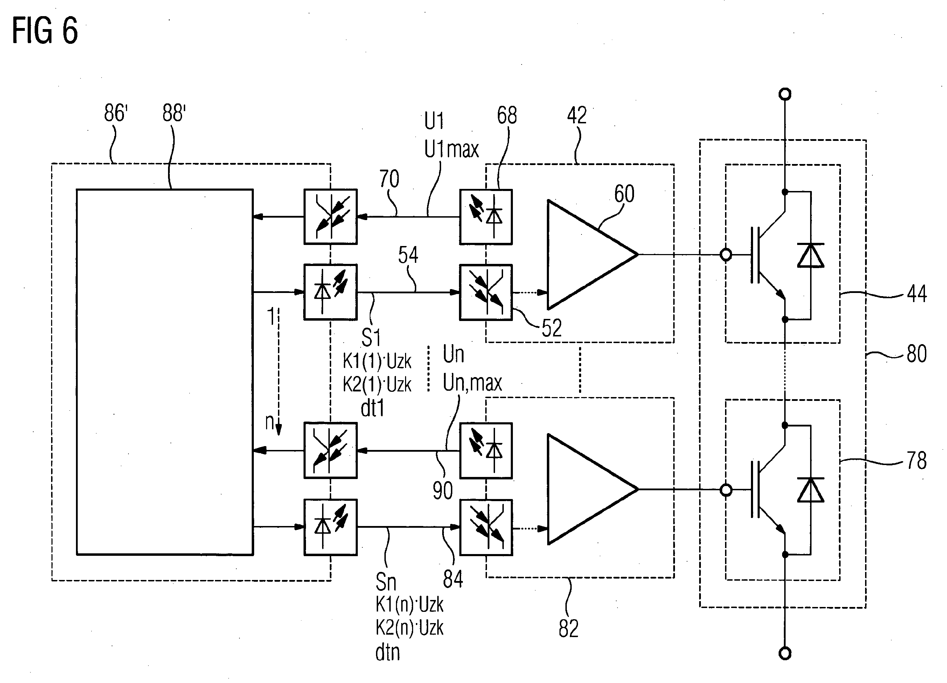

Die in FIG 6 gezeigte Variante basiert auf der Messung der aktuellen Spannungswerte U1 und U1max, wie sie durch die Ansteuerschaltung 42 durchgeführt wird, einer Messung entsprechender aktueller Spannungswerte Un und Un,max, wie sie durch die Ansteuerschaltung 82 durchgeführt wird, sowie entsprechender Messungen weiterer aktueller Spannungswerte durch die übrigen Ansteuerschaltungen des Halbbrücken-Zweigs 74 (siehe FIG 4). Die Ansteuerschaltung 42 überträgt die Messwerte über die Signalleitung 70, die Ansteuerschaltung 82 über eine entsprechende Signalleitung 90, die übrigen Ansteuerschaltungen über weitere, entsprechende Signalleitungen an eine Wechselrichtersteuerung 86' der in FIG 6 gezeigten Variante.

Innerhalb der Wechselrichtersteuerung 86' berechnet eine Signalgebereinrichtung 88' aus den Werten U1 bis Un die aktuelle Zwischenkreisspannung Uzk und (in Kombination mit den Spartnungswerten U1max bis Un,max) die daraus resultierenden Spannungshöchstwerte K1(1)*Uzk bis K1(n)*Uzk sowie die Spannungsendwerte K2(1)*Uzk bis K2(n)*Uzk.

Diese Werte werden als Parameterwerte zusammen mit den Schaltsignalen S1 bis Sn in der im Zusammenhang mit FIG 5 beschriebenen Weise an die Ansteuerschaltungen übermittelt. Zusätzlich kann vorgesehen sein, dass durch die Signalgebereinrichtung 88' anhand der empfangenen aktuellen Spannungswerte U1 bis Un und U1max bis Un,max Laufzeitdifferenzen zwischen den einzelnen Ansteuerschaltungen ermittelt werden und entsprechende Verzögerungszeiten dt1 bis dtn bestimmt und ebenfalls als Parameterwerte für entsprechende Schaltparameter an die Ansteuerschaltungen übermittelt werden.

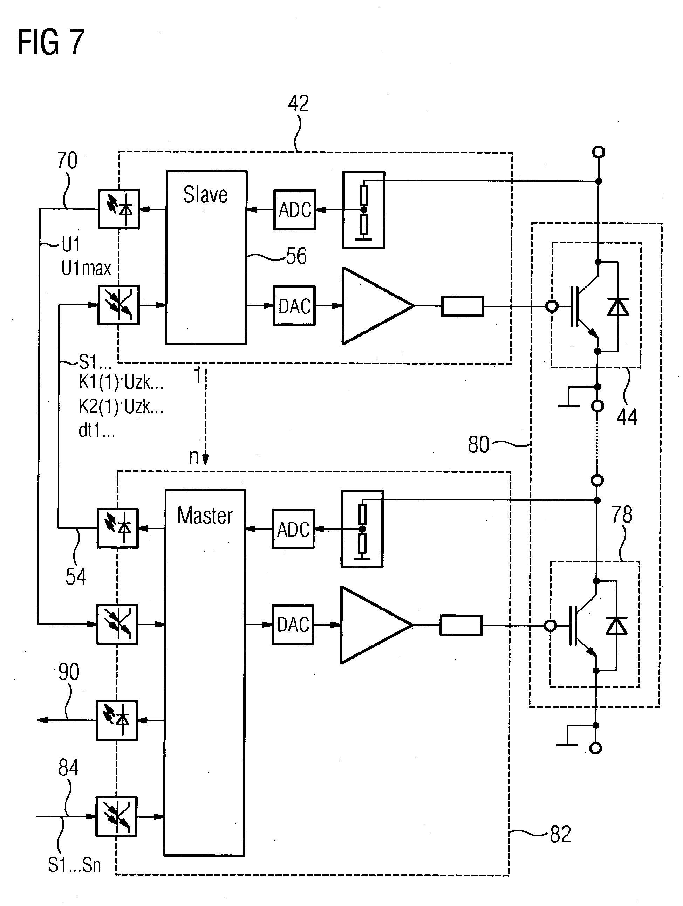

In FIG 7 ist eine Variante gezeigt, bei welcher die Parameterwerte und die aktuellen Spannungswerte zwischen den einzelnen Ansteuerschaltungen ausgetauscht werden. Die insgesamt n Ansteuerschaltungen 42, 82 sind in einer Master-Slave-Konfiguration miteinander verschaltet. Die Ansteuerschaltung 82 ist hier als Master-Ansteuerung konfiguriert, d.h. sie ist die einzige Ansteuerschaltung des Halbbrücken-Zweigs 74, die mit der Wechselrichtersteuerung über ihre Signalleitungen 84, 90 verbunden ist.

Die Ansteuerschaltung 82 empfängt die Schaltsignale S1 bis Sn für sämtliche Ansteuerschaltungen 42, 82 des Halbbrücken-Zweigs 74 und überträgt die empfangenen Schaltsignale (bis auf das für sie selbst bestimmte) an die übrigen, als Slave-Ansteuerungen konfigurierten Ansteuerschaltungen 42 etc. Die Kommunikationsverbindungen zwischen den einzelnen Ansteuerschaltungen über die Signalleitungen 54, 70 und die übrigen, nicht dargestellten Signalleitungen können dabei als Ringbusverbindung ausgeführt sein.

An die Master-Ansteuerung (Ansteuerschaltung 82) werden von den übrigen Ansteuerschaltungen 42 die jeweiligen, aktuellen Spannungswerte U1, U1max etc. sowie weitere Rückmeldesignale übertragen.

Es kann vorgesehen sein, dass Spannungshöchstwerte K1(1)*Uzk bis K1(n)*Uzk und/oder Spannungsendwerten K2(1)*Uzk bis K2(n)*Uzk und ggf. auch Verzögerungszeiten dt1 bis dtn von der Master-Ansteuerung, d.h. der Ansteuerschaltung 82, berechnet werden. Der dazu benötigte Wert für die Zwischenkreisspannung Uzk kann jeweils durch Aufsummieren der einzelnen Spannungswerte U1 bis Un in der Master-Ansteuerung ermittelt werden. Diese Variante entspricht der in FIG 7 dargestellten Konfiguration. Über die Signalleitung 84 müssen dann lediglich die Schaltsignale S1 bis Sn übertragen werden.

In einer weiteren Variante der Master-Slave-Konfiguration werden die aktuellen Spannungswerte U1 bis Un und U1max bis Un,max sowie die übrigen Rückmeldesignale über die Signalleitung 90 von der Master-Ansteuerung an die Wechselrichtersteuerung übertragen. Dort können dann durch eine Signalgebereinrichtung, die dann in ihrer Funktion der Signalgebereinrichtung 88' entspricht, die genannten Parameterwerte ermittelt und zusammen mit den Schaltsignalen S1 bis Sn an die Master-ansteuerung übermittelt werden.

Durch die Beispiele ist gezeigt, wie sich durch Bereitstellen einer digitalen Steuereinrichtung eine Ansteuerschaltung im Betrieb ständig neu konfigurieren bzw. parametrieren lässt. Dadurch entsteht die Möglichkeit, der Ansteuerschaltung im Betrieb Parameter zur Beeinflussung des Betriebsverhaltens zu übermitteln. Es ist somit möglich, das Schaltverhalten der Ansteuerschaltungen über Signalleitungen aktiv zu beeinflussen, um in einer Reihen- oder Serienschaltung von Halbleiterschaltern die Spannungssymmetrierung zu beeinflussen. Im Einzelnen ist durch die beschriebene Erfindung folgendes ermöglicht:
- eine digital programmierbare Steuereinrichtung für eine Ansteuerschaltung mit der Möglichkeit zur Neukonfiguration bzw. Veränderung von Betriebsparametern im Betrieb,
- eine Symmetrierung einer Reihenschaltung von Halbleiterschaltern mittels der digitalen Steuereinrichtung durch Erfassen der Zwischenkreisspannung und Bestimmung entsprechender Grenz- bzw. Sollwerte,
- eine codierte Übertragung der Grenz- bzw. Sollwerte zusammen mit der Schaltinformation an die Steuereinrichtungen der einzelnen Ansteuerschaltungen mittels einer Lichtwellenleiter-Verbindung,
- die Übernahme der Grenz- bzw. Sollwerte durch die Steuereinrichtungen und die Begrenzung der über den Halbleiterschaltern abfallenden Spannungen auf die übertragenen Grenzwerte bzw. das Einstellen dieser Spannungen auf die übertragenen Sollwerte,
- eine Übertragung der Grenz- bzw. Sollwerte und der Schaltinformationen mit Hilfe eines fehlertoleranten Übertragungsprotokolls zur Erhöhung der Betriebssicherheit,
- die Rückmeldung der Spannungs-Istwerte über ein fehlertolerantes Übertragungsprotokoll und die Berechnung der Grenz- bzw. Sollwerte aus den zurückgemeldeten Istwerten in der zentralen Wechselrichtersteuerung,
- eine Online-Übertragung einer pro Ansteuerschaltung vorgebbaren Zeitverzögerung zur Symmetrierung der Spannungsaufteilung an den Halbleiterschaltern in der Reihenschaltung.

## Patentansprüche

1. Schaltungsanordnung (74,76) mit einer Reihenschaltung (80) aus zumindest zwei Halbleiterschaltern (44,78), von denen jeder über seinen Steuereingang (50) mit einer jeweiligen Ansteuerschaltung (42,82) verbunden ist, die ausgelegt ist, den Halbleiterschalter (44,78) in Abhängigkeit von einem vorgebbaren Schaltsignal (S1,Sn) zu schalten, wobei während eines Schaltvorgangs ein Schaltverhalten von zumindest einer der Ansteuerschaltungen (42,82) durch zumindest einen digitalen Schaltparameter festgelegt ist, dessen Wert (K1*Uzk, K2*Uzk, K1(1)*Uzk, K2(1)*Uzk, K1(n)*Uzk, K2(n)*Uzk, dt1, dtn) veränderbar ist, so dass das Schaltverhalten im Betrieb einstellbar ist,
**dadurch gekennzeichnet, dass**
die Schaltungsanordnung dazu ausgelegt ist, zum Unterbrechen eines Stromes sämtliche Halbleiterschalter (44, 78) der Reihenschaltung in einen sperrenden Zustand zu schalten, und
a) zumindest eine der Ansteuerschaltungen (42,82) eine Spannungsüberwachungseinrichtung (64) aufweist, die dazu ausgebildet ist, eine über dem durch die Ansteuerschaltung (42, 82) angesteuerten Halbleiterschalter (44, 78) abfallende Spannung (Ud, Uce, U1max, Un,max) zu überwachen und, falls die Spannung (Ud, Uce, U1max, Un,max) größer als ein Grenzwert (K1*Uzk, K1(1)*Uzk, K1(n)*Uzk) ist, die Spannung (Ud, Uce, U1max, Un,max) durch Einwirken auf den Schaltvorgang zu verringern, wobei der Grenzwert (K1*Uzk, K1(1)*Uzk, K1(n)*Uzk) als ein Schaltparameter der Ansteuerschaltung (42, 82) für ein Regelverhalten derselben einstellbar ist, wobei die Ansteuerschaltung (42, 82) dazu ausgelegt ist, durch das Regelverhalten die Spannung über dem Halbleiterschalter (44, 78) auf einen Höchstwert zu begrenzen,
und/oder
b) bei zumindest einer der Ansteuerschaltungen (42,82) als Schaltparameter ein Spannungsendwert (K2*Uzk, K2(1)*Uzk, K2(n)*Uzk) einstellbar ist, welchen eine über dem durch die Ansteuerschaltung (42,82) angesteuerten Halbleiterschalter (44,78) abfallende Spannung (Ud, Uce, U1, Un) am Ende eines Schaltvorganges aufweisen soll, wobei die Ansteuerschaltung (42,82) dazu ausgelegt ist, zum Einstellen des Spannungsendwerts (K2*Uzk, K2(1)*Uzk, K2(n)*Uzk) zum Abschluss des Schaltvorganges zumindest einen Symmetrierimpuls am Steuereingang (50) des Halbleiterschalters (44,78) zu erzeugen.

2. Schaltungsanordnung (74,76) nach Anspruch 1, bei welcher bei zumindest einer der Ansteuerschaltungen (42,82) als Schaltparameter eine Schaltverzögerung (dt1, dtn) einstellbar ist und bei welcher diese Ansteuerschaltung (42,82) dazu ausgelegt ist, nach Empfang des Schaltsignals (S1,Sn) einen Schaltvorgang um die eingestellte Schaltverzögerung (dt1,dtn) verzögert zu beginnen.

3. Schaltungsanordnung (74,76) nach einem der Ansprüche 1 oder 2, wobei zumindest eine der Ansteuerschaltungen (42, 82) eine Spannungsmesseinrichtung (64) zum Messen einer über zumindest einem der Halbleiterschalter (44,78) abfallenden Spannung (Ud,Uce) sowie einen Messausgang (68) aufweist, an welchem ein Messwert (U1, U1max, Un, Un,max) auslesbar ist.

4. Schaltungsanordnung (74,76) nach einem der vorhergehenden Ansprüche mit einer Stelleinrichtung (88,88'), die dazu ausgelegt ist, eine über sämtliche Halbleiterschalter (44,78) abfallende Gesamtspannung (Uzk) zu ermitteln und aus der ermittelten Gesamtspannung (Uzk) zu jedem Halbleiterschalter (44,78) einen Teilspannungswert zu ermitteln und die ermittelten Teilspannungswerte als Parameterwerte (K1*Uzk, K2*Uzk, K1(1)*Uzk, K2(1)*Uzk, K1(n)*Uzk, K2(n)*Uzk) an die jeweils zugehörige Ansteuerschaltung (42,82) zu übertragen.

5. Schaltungsanordnung (74,76) nach einem der vorhergehenden Ansprüche mit einer Stelleinrichtung (88,88'), die dazu ausgelegt ist, zu zumindest einer Ansteuerschaltung (42,82) einen Wert zu ermitteln, welcher einen Zeitversatz zwischen dem Beginn von Schaltvorgängen der Ansteuerschaltungen (42,82) verursacht, und aus dem ermittelten Wert eine Zeitverzögerung zu ermitteln und die ermittelte Zeitverzögerung als Parameterwert (dt1, dtn) an eine der Ansteuerschaltungen (42,82) zu übertragen.

6. Schaltungsanordnung (74,76) nach einem der vorhergehenden Ansprüche, bei welcher zumindest eine der Ansteuerschaltungen (42,82) dazu ausgelegt ist, ein Signal über eine Lichtwellenleiter-Verbindung (54,70,84,90) mit einem externen Gerät (86, 86') auszutauschen.

7. Schaltungsanordnung (74,76) nach einem der vorhergehenden Ansprüche, bei welcher zumindest eine der Ansteuerschaltungen (42,82) dazu ausgelegt ist, ein Signal mittels einem fehlertoleranten Übertragungsprotokoll mit einem externen Gerät (86,86') auszutauschen.

8. Schaltungsanordnung (74,76) nach einem der vorhergehenden Ansprüche, bei welcher eine der Ansteuerschaltungen (42,82) als Master-Ansteuerung (82) und zumindest eine andere als Slave-Ansteuerung (42) betrieben wird, wobei die Slave-Ansteuerung (42) Daten mit einer Signalgebereinrichtung (88, 88') der Schaltungsanordnung (74,76), welche Schaltsignale (S1,Sn) für die Ansteuerschaltungen erzeugt, über die Master-Ansteuerung (82) austauscht.

9. Schaltungsanordnung (74,76) nach einem der vorhergehenden Ansprüche, bei welcher die Ansteuerschaltungen (42,82) Daten über einen Ringbus miteinander austauschen.

## Claims

1. Circuit arrangement (74, 76) with a series circuit (80) comprising at least two semiconductor switches (44, 78), each of which is connected via its control input (50) to a respective actuation circuit (42, 82), which is configured such as to switch the semiconductor switches (44, 78) as a function of a predeterminable switching signal (S1, Sn), wherein, during a switching process, a switching behaviour of at least one of the actuation circuits (42, 82) is determined by at least one digital switching parameter, the value of which (K1*Uzk, K2*Uzk, K1(1)*Uzk, K2(1)*Uzk, K1(n)*Uzk, K2(n)*Uzk, dt1, dtn) can be changed, such that the switching behaviour can be set during operation,
**characterised in that**
the circuit arrangement is configured to switch all semiconductor switches (44, 78) in the series circuit into a blocking state, in order to interrupt a current, and
a) at least one of the actuation circuits (42, 82) has a voltage monitoring facility (64), which is embodied so as to monitor a voltage (Ud, Uce, U1max, Un,max) falling over the semiconductor switch (44, 78) actuated by the actuation circuit (42, 82) and, if the voltage (Ud, Uce, U1max, Un,max) is greater than a limit value (K1*Uzk, K1(1)*Uzk, K1(n)*Uzk), to reduce the voltage (Ud, Uce, U1max, Un,max) by taking effect on the switching process, wherein the limit value (K1*Uzk, K1(1)*Uzk, K1(n)*Uzk) can be adjusted as a switching parameter of the actuation circuit (42, 82) for the control behaviour of said circuit, wherein the actuation circuit (42, 82) is embodied to limit the voltage over the semiconductor switch (44, 78) to a maximum value by the control behaviour,
and/or
b) at at least one of the actuation circuits (42, 82), a voltage end value (K2*Uzk, K2(1)*Uzk, K2(n)*Uzk) can be set as a switching parameter, which is intended to have a voltage (Ud, Uce, U1 Un) falling over the semiconductor switch (44, 78) actuated by the actuation circuit (42, 82) at the end of a switching process, wherein the actuation circuit (42, 82) is configured such as to produce at least one symmetry balancing pulse at the control input (50) of the semiconductor switch (44, 78), for the adjustment of the voltage end value (K2*Uzk, K2(1)*Uzk, K2(n)*Uzk) at the end of the switching process.

2. Circuit arrangement (74, 76) according to claim 1, wherein a switching delay (dt1, dtn) can be set for at least one of the actuation circuits (42, 82) as a switching parameter, and whereby this actuation circuit (42, 82) is configured in such a way as to begin a switching process in a manner delayed by the switching delay (dt1, dtn) which has been set, after receipt of the switching signal (S1, Sn).

3. Circuit arrangement (74, 76) according to either claim 1 or claim 2, wherein at least one of the actuation circuits (42, 82) has a voltage measuring facility (64) for measuring a voltage (Ud, Uce) falling over at least one of the semiconductor switches (44, 78), as well as a measurement output (68) at which a measured value (U1, U1max, Un, Un,max) can be read out.

4. Circuit arrangement (74, 76) according to one of the preceding claims, with a setting facility (88, 88') which is arranged so as to determine an overall voltage (Uzk) falling over all the semiconductor switches (44, 78), and, from the overall voltage (Uzk) determined, to determine a part voltage value for each semiconductor switch (44, 78), and to transfer the part voltage values determined as parameter values (K1*Uzk, K2*Uzk, K1(1)*Uzk, K2(1)*Uzk, K1(n)*Uzk, K2(n)*Uzk) to the respective actuation circuit (42, 82) allocated in each case.

5. Circuit arrangement (74, 76) according to one of the preceding claims, with a control facility (88, 88') which is configured such as to determine, at at least one actuation circuit (42, 82), a value which causes a time displacement between the beginning of switching processes of the actuation circuits (42, 82), and to determine a time delay from the value determined in this way, and to transfer the determined time delay as a parameter value (dt1, dtn) to one of the actuation circuits (42, 82).

6. Circuit arrangement (74, 76) according to one of the preceding claims, wherein at least one of the actuation circuits (42, 82) is configured in such a way as to exchange a signal via an optical waveguide connection (54,70,84,90) with an external device (86, 86').

7. Circuit arrangement (74, 76) according to one of the preceding claims, wherein at least one of the actuation circuits (42, 82) is arranged in such a way as to exchange a signal with an external device (86, 86') by means of a fault-tolerant transfer protocol.

8. Circuit arrangement (74, 76) according to one of the preceding claims, wherein one of the actuation circuits (42, 82) is operated as a master actuator (82) and at least one other is operated as a slave actuator (42), wherein the slave actuator (42) exchanges data with a signal-generating facility (88, 88') of the circuit arrangement (74, 76), which generates switching signals (S1, Sn) for the actuation circuits, via the master actuator (82).

9. Circuit arrangement (74, 76) according to one of the preceding claims, wherein the actuation circuits (42, 82) exchange data with each other via a ring bus.

## Revendications

1. Montage (74, 76), comprenant un circuit (80) série composé d'au moins deux commutateurs (44, 78) à semiconducteurs, dont chacun est relié, par son entrée (50) de commande, à un circuit (42, 82) de commande respectif, conçu pour commuter le commutateur (44, 78) à semiconducteurs en fonction d'un signal (S1, Sn) de commutation pouvant être donné à l'avance, dans lequel, pendant une opération de commutation, un comportement de commutation d'au moins l'un des circuits (42, 82) de commande est fixé par au moins un paramètre de commutation numérique, dont la valeur (K1*Uzk, K2*Uzk, K1(1)*Uzk, K2(1)*Uzk, K1(n)*Uzk, K2(n)*Uzk, dt1, dtn) peut être modifiée, de manière à pouvoir régler le comportement de commutation en fonctionnement,
**caractérisé en ce que**
le montage est conçu pour, afin d'interrompre un courant, mettre tous les commutateurs (44, 78) à semiconducteurs du circuit série dans un état bloqué et
a) au moins l'un des circuits (42, 82) de commande a un dispositif (64) de contrôle de la tension, qui est conçu pour contrôler une tension (Ud, Uce, U1max, Un,max) chutant aux bornes du commutateur (44, 78) à semiconducteurs commandé par le circuit (42, 82) de commande et, si la tension (Ud, Uce, U1max, Un,max) est plus haute qu'une valeur (K1*Uzk, K1(1)*Uzk, K1(n)*Uzk) limite, abaisser la tension (Ud, Uce, U1max, Un,max) en agissant sur l'opération de commutation, la valeur (K1*Uzk, K1(1)*Uzk, K1(n)*Uzk) limite pouvant être réglée, comme paramètre de commutation du circuit (42, 82) de commande, pour une action de réglage de celui-ci, le circuit (42, 82) de commande étant conçu pour, par l'action de réglage, limiter à une valeur la plus haute la tension aux bornes du commutateur (44, 78) à semiconducteurs,
et/ou
b) pour au moins l'un des circuits (42, 82) de commande, on peut régler, comme paramètre de commutation, une valeur (K2*Uzk, K2(1)*Uzk, K2(n)*Uzk) finale de tension que doit avoir, à la fin d'une opération de commutation, une tension (Ud, Uce, U1, Un) chutant aux bornes d'un commutateur (44, 78) à semiconducteurs commandé par le circuit (42, 82) de commande, le circuit (42, 82) de commande étant conçu pour produire, pour le réglage de la valeur (K2*Uzk, K2(1)*Uzk, K2(n)*Uzk) finale de tension à la fin de l'opération de commutation, au moins une impulsion de symétrisation à l'entrée (50) de commande du commutateur (44, 78) à semiconducteurs.

2. Montage (74, 76) suivant la revendication 1, dans lequel, pour au moins l'un des circuits (42, 82) de commande, un retard (dt1, dtn) de commutation peut être réglé comme paramètre de commutation et dans lequel ce circuit (42, 82) de commande est conçu pour faire commencer, après la réception du signal (S1, Sn) de commutation, une opération de commutation retardée du retard (dt1, dtn) de commutation réglé.

3. Montage (74, 76) suivant l'une des revendications 1 ou 2, dans lequel au moins l'un des circuits (42, 82) de commande a un dispositif (64) de mesure de tension pour mesurer une tension (Ud, Uce) chutant aux bornes d'au moins l'un des commutateurs (44, 78) à semiconducteurs, ainsi qu'une sortie (68) de mesure, à laquelle une valeur (U1, U1max, Un, Un,max) de mesure peut être lue.

4. Montage (74, 76) suivant l'une des revendications précédentes, comprenant un dispositif (88, 88') de réglage, qui est conçu pour déterminer une tension (Uzk) globale chutant aux bornes de tous les commutateurs (44, 78) à semiconducteurs et pour déterminer, à partir de la tension (Uzk) globale déterminée, pour chaque commutateur (44, 78) à semiconducteurs, une valeur de tension partielle et pour transmettre les valeurs de tension partielle déterminées comme valeurs (K1*Uzk, K2*Uzk, K1(1)*Uzk, K2(1)*Uzk, K1(n)*Uzk, K2(n)*Uzk ) de paramètre aux circuits (42, 82) de commande associés respectifs.

5. Montage (74, 76) suivant l'une des revendications précédentes, comprenant un dispositif (88, 88') de réglage, qui est conçu pour déterminer, pour au moins l'un des circuits (42, 82) de commande, une valeur, qui provoque un décalage dans le temps entre les opérations de commutation des circuits (42, 82) de commande, et pour déterminer, à partir de la valeur déterminée, un retard dans le temps et pour transmettre le retard dans le temps déterminé comme valeur (dt1, dtn) de paramètre à l'un des circuits (42, 82) de commande.

6. Montage (74, 76) suivant l'une des revendications précédentes, dans lequel au moins l'un des circuits (42, 82) de commande est conçu pour échanger avec un appareil (86, 86') extérieur un signal par une liaison (54, 70, 84, 90) par fibre optique.

7. Montage (74, 76) suivant l'une des revendications précédentes, dans lequel au moins l'un des circuits (42, 82) de commande est conçu pour échanger avec un appareil (86, 86') extérieur un signal au moyen d'un protocole de transmission tolérant aux erreurs.

8. Montage (74, 76) suivant l'une des revendications précédentes, dans lequel l'un des circuits (42, 82) de commande fonctionne comme commande (82) maître et au moins un autre comme commande (42) esclave, la commande (42) esclave échangeant, en passant par la commande (82) maître, des données avec un dispositif (88, 88') donnant un signal du montage (74, 76), qui produit des signaux (S1, Sn) de commutation pour les circuits de commande.

9. Montage (74, 76) suivant l'une des revendications précédentes, dans lequel les circuits (42, 82) de commande échangent des données entre eux par un bus en anneau.
